# EUROPEAN PATENT APPLICATION

(11) **EP 2 031 717 A2**
(43) Date of publication of application: **04.03.2009**
(21) Application number: 08004855.6
(22) Date of filing: 14.03.2008
(51) Int. Cl.: H01S 5/343, H01S 5/22

(54) **Semiconductor light emitting element**

(30) Priority: 31.08.2007 JP 2007226417
(71) Applicant: Kabushiki Kaisha Toshiba, Minato-ku, Tokyo 105-8001 (JP)
(72) Inventor: Tachibana, Koichi, Tokyo 105-8001 (JP); Saito, Shinji, Tokyo 105-8001 (JP); Nunoue, Shinya, Tokyo 105-8001 (JP); Yoshida, Haruhiko, Tokyo 105-8001 (JP)
(74) Representative: HOFFMANN EITLE

(57) **Abstract**

A semiconductor light emitting element includes a first clad layer (14) of a first conductivity type provided on a substrate (10); an active layer (18) provided on the first clad layer (14); a second clad layer (26) of a second conductivity type provided on the active layer (18), an upper portion of the second clad layer (26) implements a ridge (32) extending in a predetermined direction; a pair of first current block layers (4) provided on the second clad layer (26) sandwiching the ridge (32) along the extending direction; and a pair of second current block layers (6) provided between the first current block layers (4) on the second clad layer (26) and at sidewalls of the ridge to be contacted with the first current block layers, sandwiching selectively a region including an edge of the ridge (32), the second current block layers (6) having a refractive index larger than the first current block layers (4) at an emission peak wavelength of the active layer (18).

## Description

### CROSS REFERENCE TO RELATED APPLICATIONS AND INCORPORATION BY

### REFERENCE

This application is based upon and claims the benefit of priority from prior Japanese Patent Application P2007-226417 filed on August 31, 2007; the entire contents of which are incorporated by reference herein.

### BACKGROUND OF THE INVENTION

### 1. Field of the Invention

The present invention relates to a semiconductor light emitting element, such as a laser diode and the like, and more particularly relates to a nitride based semiconductor light emitting element.

### 2. Description of the Related Art

A nitride based III-V group compound semiconductor, such as gallium nitride (GaN) and the like, has a wide band gap. Semiconductor light emitting elements, such as high brightness ultraviolet to blue or green light emitting diodes (LEDs), blue-violet laser diodes (LDs), and the like, have been investigated and developed using features of the nitride based semiconductor.

Along with the advancement of crystal growth techniques, process techniques and the like, higher power nitride based semiconductor light emitting elements have been developed. However, with high intensity light output operation of a semiconductor light emitting element, even in a pulse operation, the light intensity density at an end face (or edge) of the semiconductor light emitting element is increased, which damages the end face, where a couple of the end faces implementa cavityof the semiconductor light emitting element (refer to T. Kozaki et al. , "High Output and Wide Wavelength Range GaN-Based Laser Diodes", Proc. SPIE, 2006, Vol.6133, p.613306).

In order to achieve the higher intensity light output of the semiconductor light emitting element, it is necessary to provide a countermeasure to the damage of end faces. For example, by using a window structure at the end face of the light emitting element in an indium gallium aluminum phosphide (InGaAlP) based LD, light absorption in the region near the end face is decreased, so as to achieve a highly reliable high light intensity output LDy. However, in a nitride based semiconductor, it is difficult to reduce the film thickness of a quantum well near the end face of the element, or to diffuse impurities, in order to form a window structure.

In order to improve laser characteristics of the LD for a high intensity light output operation, a method which changes a light confinement coefficient in a GaN based semiconductor layer near the end face of the element has been proposed (refer to JP-A 2005-302843 (KOKAI)). Also, a method in which a refractive index of a clad layer is changed near the end face has been proposed (refer to Japanese Patent Publication No.3786054). However,when the light confinement coefficient of the semiconductor layer or the refractive index of the clad layer is changed near the end face, resistivity of the semiconductor layer is changed. As a result, the injection current density into the active layer is changed, and the laser characteristics may be adversely influenced.

### SUMMARY OF THE INVENTION

A first aspect of the present invention inheres in a semiconductor light emitting element including a first clad layer of a first conductivity type provided on a substrate; an active layer provided on the first clad layer; a second clad layer of a second conductivity type provided on the active layer, an upper portion of the second clad layer implements a ridge extending in a predetermined direction; a pair of first current block layers provided on a lower surface of the second clad layer so as to sandwich the ridge along the extending direction of the ridge; and a pair of second current block layers provided between the first Current block layers on the lower surface of the second clad layer and at sidewalls of the ridge so as to be contacted with the first current block layers, sandwiching selectively a region including an edge of the ridge, each of the second current block layers having a refractive index larger than the first current block layers at an emission peak wavelength of the active layer.

A second aspect of the present invention inheres in a semiconductor light emitting element including a first clad layer of a first conductivity type provided on a substrate; an active 5 layer provided on the first clad layer; a second clad layer of a second conductivity type provided on the active layer, an upper portion of the second clad layer implements a ridge extending in a predetermined direction; a pair of first current block layers provided on a lower surface of the second clad layer so as to sandwich the ridge along the extending direction of the ridge, each of the first current block layers having a refractive index less than the active layer at an emission peak wavelength of the active layer; and a pair of second current block layers provided between the first current block layers on the lower surface of the second clad layer and at sidewalls of the ridge so as to be contacted with the first current block layers, sandwiching selectively a region including an edge of the ridge, each of the second current block layers having a refractive index larger than the first current block layers and equal to or less than the second clad layer at the emission peak wavelength.

### BRIEF DESCRIPTION OF DRAWINGS

FIG. 1 is a schematic plan view showing an example of a semiconductor light emitting element according to an embodiment of the present invention;
FIG. 2 is a schematic view taken on line II-II of the light emitting element shown in FIG. 1;
FIG. 3 is a schematic view taken on line III-III of the light emitting element shown in FIG. 1;
FIG. 4 is a view showing an example of a relation between a light intensity density and a width of a second current block layer of the semiconductor light emitting element according to the embodiment of the present invention;
FIG. 5 is a view showing an example of a relation between the light intensity density and a length of the second current block layer of the semiconductor light emitting element according to the embodiment of the present invention;
FIGs. 6 to 11 are cross sectional views showing an example of a manufacturing method of the semiconductor light emittingelement according to the embodiment of the present invention;
FIG. 12 is a schematic plan view showing another example of the semiconductor light emitting element according to the embodiment of the present invention; and
FIG. 13 is a cross sectional view showing an example of a light emitting device according to an application example of the embodiment of the present invention.

### DETAILED DESCRIPTION OF THE INVENTION

various embodiments of the present invention will be described with reference to the accompanying drawings. It is to be noted that the same or similar reference numerals are applied to the same or similar parts and elements throughout the drawings, and the description of the same or similar parts and elements will be omitted or simplified.

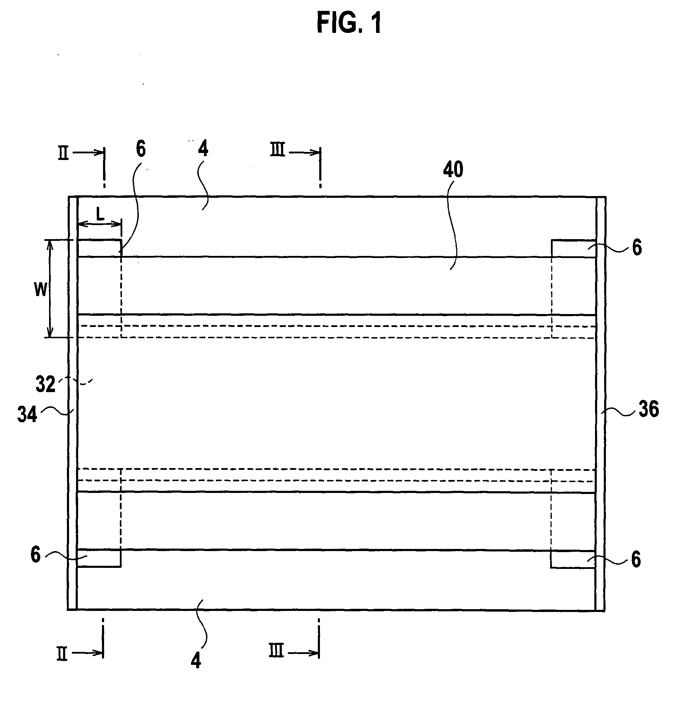

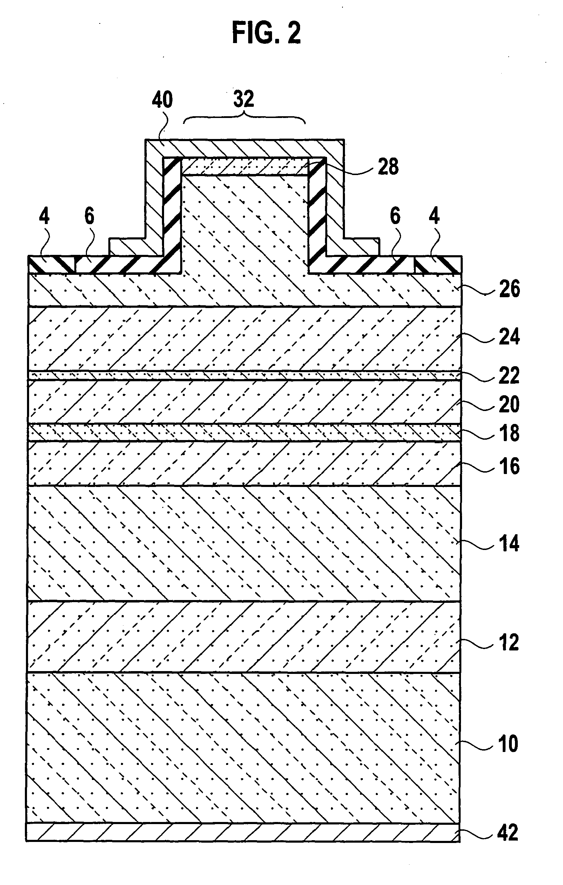

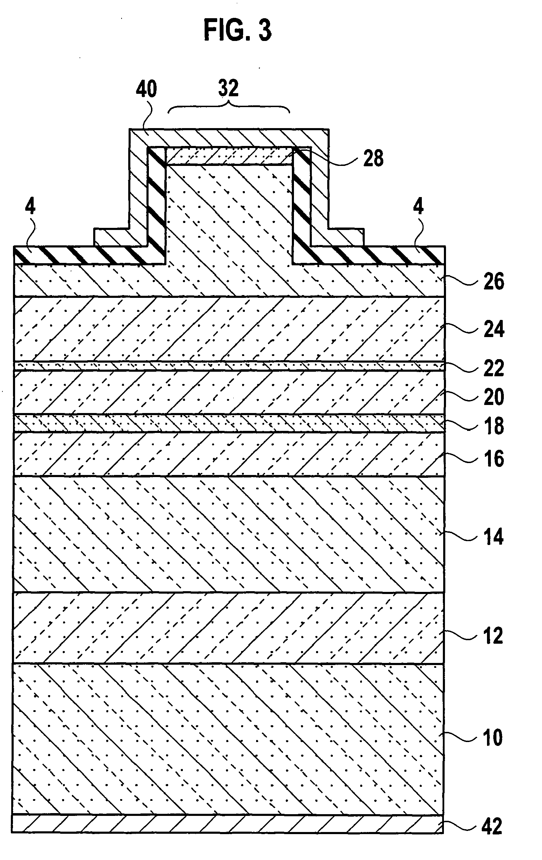

A semiconductor light emitting element according to an embodiment of the present invention is an edge emitting LD, as shown in FIGs. 1 to 3. The semiconductor light emitting element has a structure in which an n-type (first conductive type) buffer layer 12, an n-type first clad layer 14, an n-type first guide layer 16, an active layer 18, a p-type (second conductive type) second guide layer 20, a p-type electron overflow protecting layer 22, a p-type third guide layer 24, a p-type second clad layer 26 and a p-type contact layer 28 are sequentially laminated on an n-type substrate 10. A ridge 32 extending in a direction between first and second end faces of the semiconductor light emitting element, where the first and second end faces are opposite to each other so as to implement a cavity, is implemented by an upper portion of the second clad layer 26. The contact layer 28 is provided on a top surface of the ridge 32.

On a lower surface of the second clad layer 26, a pair of first current block layers 4 are provided along the extending direction of the ridge 32. The pair of first current block layers 4 sandwich the ridge 32. Also on the lower surface of the second clad layer 26 and at sidewalls of the ridge 32, two pairs of second current block layers 6, which are in contact with the first current block layer 4, are provided between the first current block layers 4 sandwiching selectively regions of the ridge 32 near the first and second end faces of the semiconductor light emitting element, respectively. The first and second current block layers 4, 6 are provided so as to cover an exposed surface of the second clad layer 26 and side surfaces of the ridge 32, respectively. Each second current block layer 6 has a width W and a length L. Here, the width W is a dimension between one of the sidewalls of the ridge 32 and a side surface of the second current block layer 6 measured along a direction perpendicular to the extending direction of the ridge 32. The length L is a dimension of the second current block layer 6 measured along the extending direction of the ridge 32. In addition, the first and second current block layers 4, 6 are formed so as to be in contact with side surfaces of each other. However, a part of the second current block layer 6 may be formed to overlap on the first current block layer 4.

A p-side electrode 40 is partially provided on a top surface of the contact layer 28 of the ridge 32 and partially on selected areas of the surfaces of the first and second current block layers 4, 6. An n-side electrode 42 is provided on a bottom surface of the substrate 10. Also, protective layers 34, 36 are provided at the first and second end faces of the semiconductor light element, respectively.

Note that the first conductivity type and the second conductivity type are opposite to each other. Specifically, if the first conductivity type is n-type, the second conductivity type is p-type, and, if the first conductivity type is p-type, the second conductivity type is n-type. In the hollowing description, for convenience, n-type is set as the first conductivitytype, andp-type is set as the second conductivity type. However, p-type may be set as the first conductivity type and n-type may be set as the second conductivity type.

A GaN substrate of (0001) orientation is used for the substrate 10. A GaN layer doped with an n-type impurity, such as silicon (Si) and germanium (Ge), at an impurity concentration of about 2×10¹⁸ cm⁻³ is used for the buffer layer 12. A Ga_{0.95}Al_{0.05}N layer having a film thickness of about 1.5 µm and doped with an n-type impurity at an impurity concentration of about 1×10¹⁸ cm⁻³ is used for the first clad layer 14. A GaN layer having a film thickness of about 0.1 µm and doped with an n-type impurity at an impurity concentration of about 1×10¹⁸ cm⁻³ is used for the first guide layer 16. An In_{0.01}Ga_{0.99}N layer may also be used for the first guide layer 16.

The active layer 18 is a light emitting layer. For example, the active layer 18 is a multiple quantum well (MQW) layer in which an undoped In_{0.1}Ga_{0.9}N quantum well layer and undoped In_{0.01}Ga_{0.99}N barrier layers are alternately laminated such that the quantum well layer is sandwiched between the barrier layers. The quantum well layer has a film thickness of about 3.5 nm and each barrier layer has a film thickness of about 7 nm. In this MQW, the peak wavelength of photoluminescence measured at room temperature is about 405 nm.

A GaN layer having a film thickness of about 90 nm and doped with a p-type impurity, such as magnesium (Mg) and zinc (Zn), at an impurity concentration of about 4×10¹⁸ cm⁻³ is used for the second guide layer 20. In addition, for the first guide layer 16, an In_{0.01}Ga_{0.99}N layer having a film thickness of about 0.1 nm may be used. A Ga_{0.8}Al_{0.2}N layer having a film thickness of about 10 nm and doped with a p-type impurity at an impurity concentration of about 4×10¹⁸ cm⁻³ is used for the electron overflow protecting layer 22. A GaN layer having a film thickness of about 50 nm and doped with a p-type impurity at an impurity concentration of about 1×10¹⁹ cm⁻³ is used for the third guide layer 24.

A Ga_{0.95}Al_{0.95}N layer having a film thickness of about 0.6 µm and doped with a p-type impurity at an impurity concentration of about 1×10¹⁹ cm⁻³ is used for the second clad layer 26. A GaN layer having a film thickness of about 60 nm doped with a p-type impurity at an impurity concentration of about 1×10²⁰ cm⁻³ is used for the contact layer 28.

The extending direction of the ridge 32 is a <1-100> direction, and orthogonal to a {1-100} cleavage plane that is the end face used as a resonator mirror. The ridge 32 has a width in a range of about 1 µm and about 3 µm and a height in a range of about 0.2 µm and about 0.6 µm.

Here, the parenthesis "{}" denotes planes in a notation system using Miller indices. For example, the {1-100} plane denotes all planesequivalentto (1-100) plane, such as (10-10), (-1100), (-1010), (01-10) and (0-110), and notation (1-100) is used to comprehensively define these planes, for convenience. Here, the bar "-" is a symbol that is used in association with a subsequent numeral. Also, the <1-100> direction denotes all directions equivalent to [1-100] direction, such as [10-10], [-1100], [-1010], [01-01] and [0-110], and notation <1-100> is used to comprehensively define these directions, for convenience.

A film having a refractive index at the laser emission peak wavelength less than that of the active layer 18 is used for the first current block layer 4. A lateral mode of an excited laser light is controlled by the first current block layer 4 provided on the surface of the second clad layer 26 and the side surfaces of the ridge 32. An insulating film, such as silicon oxide (SiO₂) and a mixture of SiO₂ and zirconium oxide (ZrO₂), a high resistivity semiconductor film, such as AlN and GaAlN, a proton-irradiated semiconductor film, or the like is used as the first current block layer 4. The first current block layer 4 has a film thickness in a range of about 0.1 µm and about 0.6 µm.

The In_{0.1}Ga_{0.9}N layer of the active layer 18 has a refractive index of about 2.6 at the laser emission peak wavelength of about 405 nm, for example. At a wavelength of about 405 nm, refractive indices of SiO₂, AlN, and Ga_{0.8}Al_{0.2}N are about 1.49, about 2.16 and about 2.44, respectively.

In addition, as the first current block layer 4, an n-type semiconductor layer, such as GaN, GaAlN and the like, may be used instead of the insulating film or the high resistivity film. In this case, the n-type semiconductor layer functions as the current block layer by pn-junction isolation.

A film having a refractive index at the laser emission peak wavelength larger than that of the first current block layer 4 is used for the second current block layer 6. Byusing the second current blocking layer 6 having a refractive index larger than the first current block layer 4, it is possible to diffuse the laser light at the end faces used as the resonator mirrors and decrease the light intensity density.

An insulating film, such as zirconium oxide (ZrO₂), tantalum oxide (Ta₂O₅) and the like, is used for the second current block layer 6. Alternately, a mixed insulating film of titanium oxide (TiO₂), and SiO₂, alumina (Al₂O₃), silicon nitride (Si₃N₄), hafnium oxide (HfO₂), AlN, ZrO₂ and the like, maybe used as the second current block layer 6.

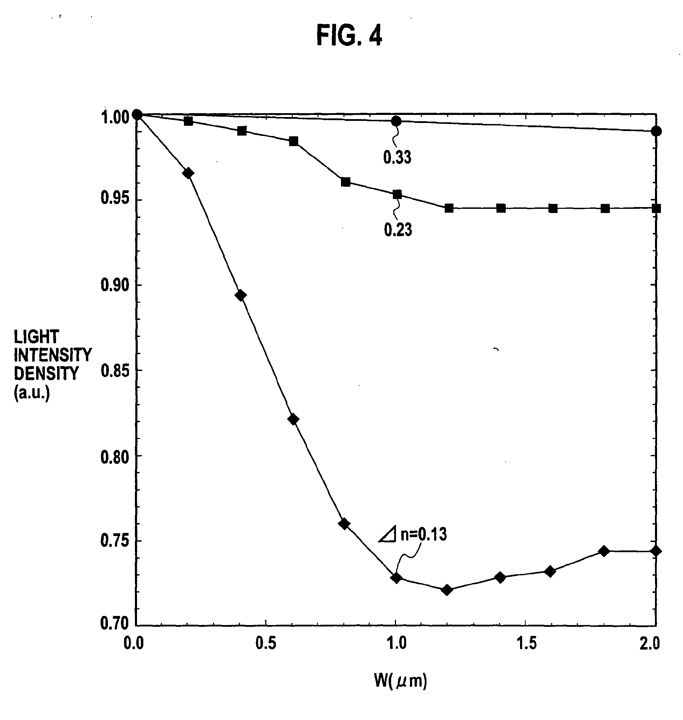

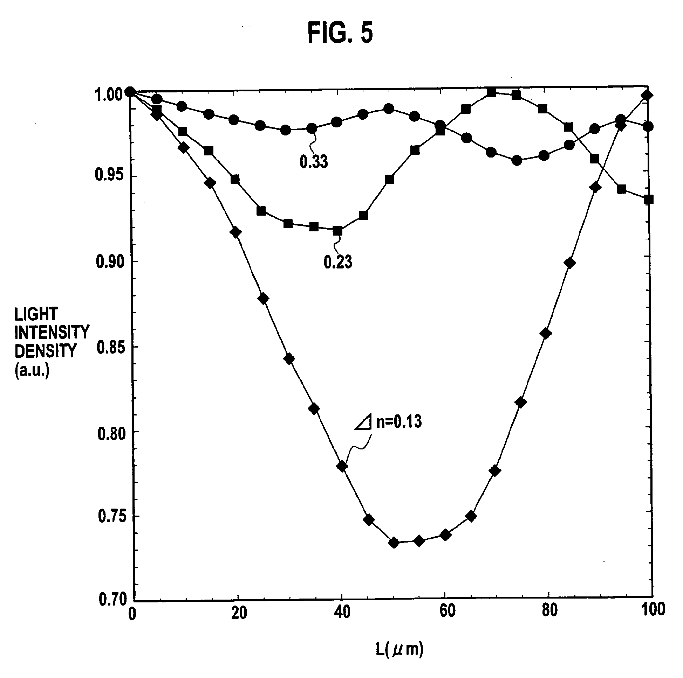

The light intensity density at the edge, where the second current block layer 6 is provided, depends on an absolute value Δn of a refractive index difference (hereafter, referred as a "refractive index difference") between the second current block layer 6 and the second clad layer 26 at the laser emission peak wavelength, and the width W and length L of the second current block layer 6. FIG. 4 shows a calculated result of the relation between the light intensity density and the width W by changing the refractive index difference Δn when the length L is about 50 µm. FIG. 5 shows a calculated result of the relation between the light intensity density and the length L by changing the refractive index difference Δn when the width W is about 1 µm.

As the light intensity density is decreased, damage at the end face is reduced. However, if the light intensity density is excessively decreased, the gain is excessively reduced. Thus, it is difficult to excite the laser. As a result, the threshold current of the laser excitation is increased and further disables the laser excitation. Therefore, the light intensity density may be in a range of about 0.7 times to about 0.99 times, and desirably about 0.7 times to about 0.95 times, with respect to the light intensity density without the second current block layer 6.

As shown in FIG. 4, the width W of the second current block layer 6 may be about 0.2 µm or more, desirably about 0.5 µm or more, and further desirably about 1 µm or more. As shown in FIG. 5, the length L of the second current block layer 6 may be in a range of about 5 µm to about 100 µm, desirably about 20 µm to about 80 µm, and further desirably about 40 µm to about 70 µm. The film thickness of the second current block layer 6 may be in a range of about 0.1 µm to about 0.6 µm, similar to the first current block layer 4.

As shown in FIGs. 4 and 5, a material of the second current block layer 6 maybe selected such that the refractive index di f f erence Δn is about 0.4 or less, desirably about 0.33 or less, further desirably in a range of about 0.02 to about 0.25, and furthermore desirably in a range of about 0.05 to about 0.15. For example, the refractive index of Ga_{0.95}Al_{0.05}N used for the second clad layer 26 is about 2.52 at a wavelength of 405 nm. Thus, the refractive index of the second current block layer 6 may be between about 2.12 and about 2.52. Specifically, ZrO₂ having a refractive index of about 2.28 can be used as the second current block layer 6. Also, as the secondcurrentblocklayer6, a mixture film of TiO₂ having are fractive index of about 2.95 and ZrO₂ may be used. For example, a refractive index of the mixture film of TiO₂ of about 16 % and ZrO₂ of about 84 % is about 2.39.

For the p-side electrode 40, for example, a composite film of palladium/platinum/gold (Pd/Pt/Au) is used. For the n-side electrode 42, for example, a composite film of titanium/platinum/gold (Ti/Pt/Au) is used. For each of the protective films 34, 36 for the end faces serving as the resonant mirror, a dielectric film is used. For example, when the end face on which the protective film 34 is formed is used as the output end face of the laser light, reflectances of the protective films 34, 36 are desirably about 10 % and about 95 %, respectively.

In the semiconductor light emitting element according to the embodiment of the present invention, the second current block layer 6 having a refractive index higher than the first current block layer 4 and equal to or lower than the second clad layer 26 in the laser emission peak wavelength, is provided in the region including the edge of the ridge 32. Thus, it is possible to reduce the light intensity density at the end face. As a result, it is possible to achieve a semiconductor light emitting element having a high light output and a high reliability, which can suppress deterioration of the end face.

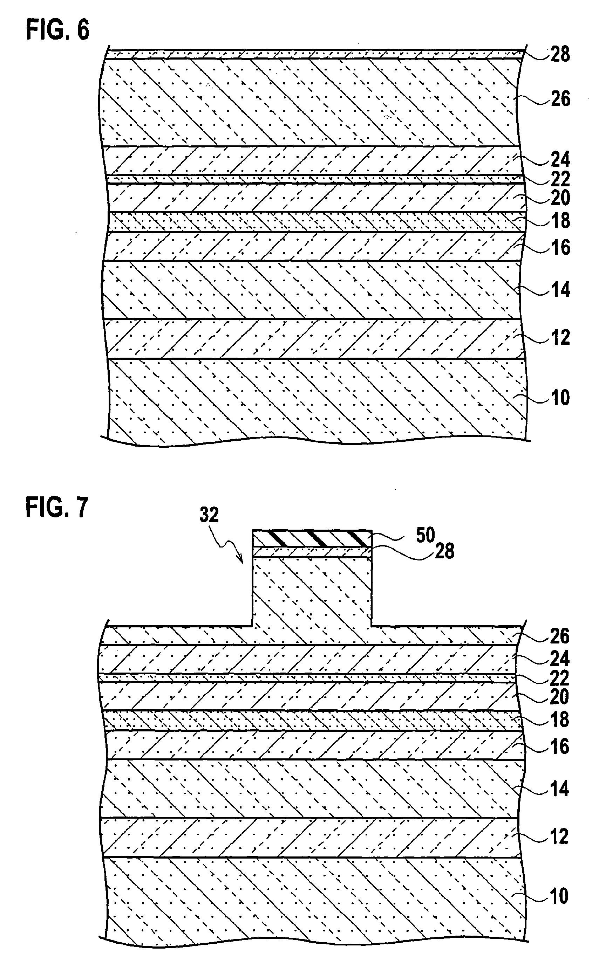

A manufacturing method of the semiconductor light emitting element according to the embodiment of the present invention will be described below by using cross sectional views and a plan view shown in FIGs. 6 to 11. In addition, the cross section corresponding to the II-II line shown in FIG. 1 is used in the description.

As shown in FIG. 6, an n-type buffer layer 12, an n-type first clad layer 14, an n-type first guide layer 16, an active layer 18, ap-type second guide layer20, ap-type electronoverflowprotecting layer 22, a p-type third guide layer 24, a p-type second clad layer 26, and a p-type contact layer 28 are sequentially grown by metal organic chemical vapor deposition (MOCVD) and the like on an n-type GaN substrate 10 of (0001) orientation, respectively.

An n-type GaN layer doped with si at an impurity concentration of about 2×10¹⁸ cm⁻³ is grown as the buffer layer 12. An n-type Ga_{0.95}Al_{0.05}N layer doped with Si at an impurity concentration of about 1×10¹⁸ cm⁻³ is grown as the first clad layer 14 at a thickness of about 1.5 µm. An n-type GaN layer doped with Si at an impurity concentration of about 1×10¹⁸ cm⁻³ is grown as the first guide layer 16 at a thickness of about 0.1 µm. The growth temperatures of the buffer layer 12, the first clad layer 14 and the first guide layer 16 are between about 1000°C and about 1100°C. Note that, as the first guide layer, an n-type In_{0.01}Ga_{0.99}N layer may be grown at a thickness of about 0.1 µm. The growth temperature of the n-type In_{0.01}Ga_{0.9}N layer is between about 700°C and about 800°C.

AMQW layer is grown as the active layer 16, in which a quantum well layer and barrier layers sandwiching the quantum well layer are laminated. The quantum well layer is an undoped In_{0.1}Ga_{0.9}N layer having a film thickness of about 3.5 nm. Each barrier layer is an undoped In_{0.01}Ga_{0.99}N layer having a film thickness of about 7 nm. The growth temperature of the active layer 18 is between about 700°C and about 800°C.

A p-type GaN layer doped with Mg at an impurity concentration of about 4×10¹⁸ cm⁻³ is grown as the second guide layer 20 at a thickness of about 90 nm. The growth temperature of the second guide layer 20 is between about 1000°C and about 1100°C. Note that, as the second guide layer 20, a p-type In_{0.01}Ga_{0.99}N layer may be grown at a thickness of about 0.1 µm. The growth temperature of the p-type In_{0.01}Ga_{0.99}N layer is between about 700°C and about 800°C.

A p-type Ga_{0.8}Al_{0.2}N layer doped with Mg at an impurity concentration of about 4×10¹⁸ cm⁻³ is grown as the electrol overflow protecting layer 22 at a thickness of 10 nm. The growth temperature of the electron overflow protecting layer 22 is between about 1000°C and about 1100°C. Note that, the growth temperature of the electron overflow protecting layer 22 may be between about 700°C and about 800°C.

A p-type GaN layer doped which Mg at an impurity concentration of about 1×10¹⁹ cm⁻³ is grown as the third guide layer 24 at a thickness of about 50 nm. The growth temperature of the third guide layer 24 is between about 1000°C and about 1100°C.

A p-type Ga_{0.95}Al_{0.05}N layer doped with Mg at an impurity concentration of about 1×10¹⁹ cm⁻³ is grown as the second clad layer 26 at a thickness of about 0.6 µm. A p-type GaN layer doped with Mg at an impurity concentration of about 1×10²⁰ cm⁻³ is grown as the contact layer 28 at a thickness of about 60 nm.

As shown in FIG. 7, a striped resist film 50 extending in the {1-100} direction and having a width of about 2 µm is formed on a surface of the contact layer 28 by photolithography and the like. The contact layer 28 and the second clad layer 26 are selectively removed by dry etching and the like while using the resist film 50 as a mask, to form a ridge 32. Subsequently, the resist film 50 is removed. Note that, a cross section shape of the ridge 32 is not limited to a rectangular shape having vertical sidewalls. A trapezoid shape having slant sidewalls is also within the scope of the invention.

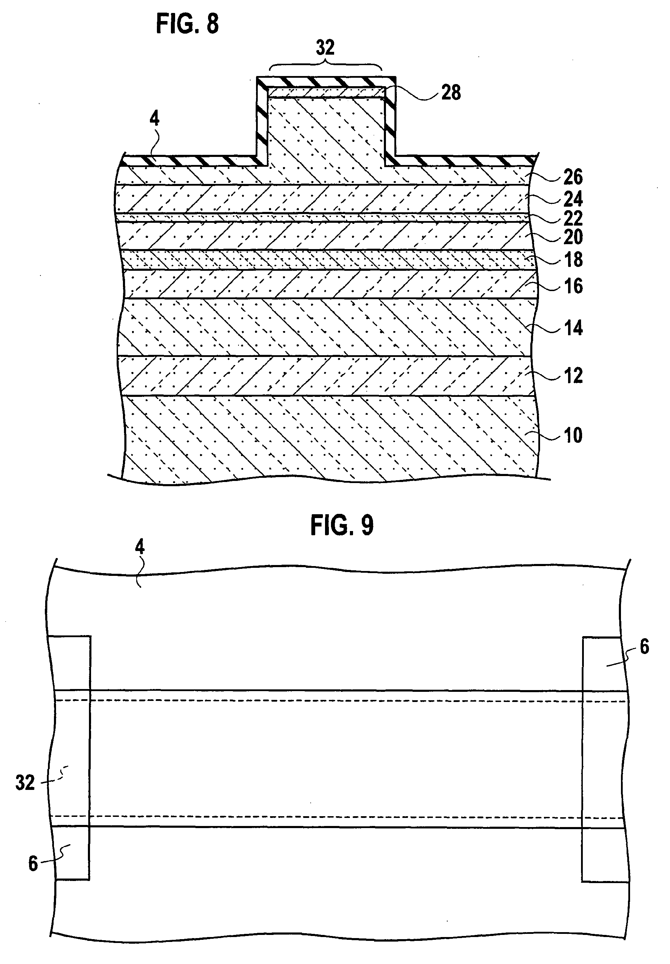

As shown in FIG. 8, a first current block layer 4, such as a SiO₂ film and the like, is deposited by CVD and the like at a thickness of about 0.5 µm on surfaces of the second clad layer 26 and the contact layer 28 where the ridge 32 is formed.

As shown in FIG. 9, the first current block layer 4 is selectively removed by photolithography, dry etching, and the like to form openings on the periphery of both edges of the ridge 32. A mixture film of about 84 % ZrO₂ and about 16 % TiO₂ is selectively deposited by electron cyclotron resonance (ECR) sputtering, photolithography, and the like, on the openings at a thickness of about 0.5 µm to form second current block layers 6. Each of the second current block layers 6 has a width of about 1 µm from each of both sidewalls of the ridge 32 and a length of about 50 µm in the extending direction of the ridge 32, at each position to be an end face of an optical resonator.

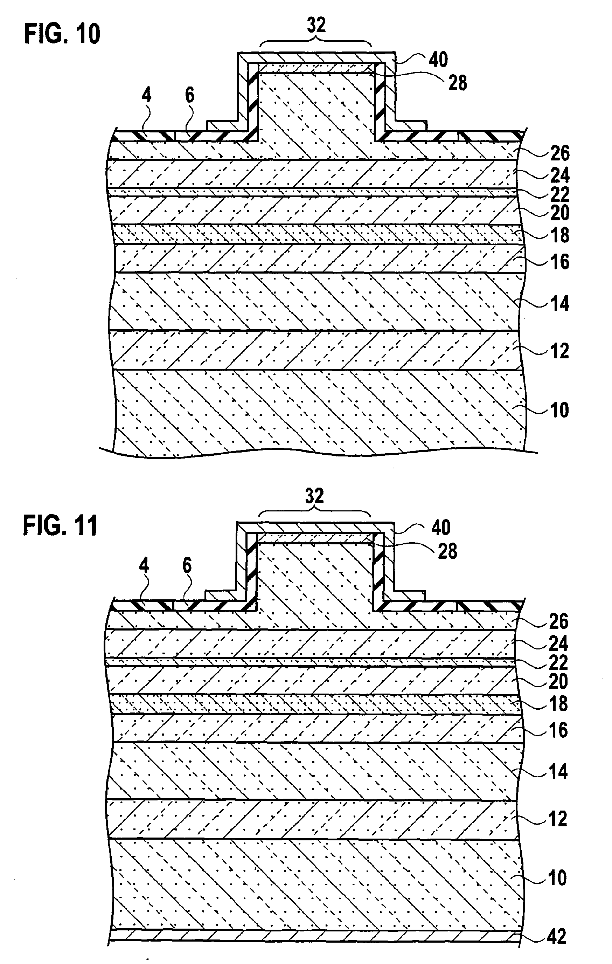

As shown in FIG. 10, the first and second current block layers 4, 6 are selectively removed by photolithography, dry etching, and the like, to expose the surface of the contact layer 28. Pd, Pt and Au are deposited by photolithography, evaporation, and the like, on the exposed surface of the contact layer 28 at thicknesses of about 0.05 µm, 0.05 µm and 1 µm, respectively to for a p-side electrode 40.

As shown in FIG. 11, a thickness of the substrate 10 is reduced to about 150 µm from a rear surface thereof by polishing and the like. Ti, Pt and Au are deposited by evaporation and the like, on the rear surface of the substrate 10 at thicknesses of about 0.05 µm, 0.05 µm and 1 µm, respectively, to form an n-side electrode 42. After forming the n-side electrode 42, optical resonators are formed by cleaving. A length of each of the optical resonators is about 600 µm. Dielectric protective films 34, 36 (refer to FIG. 1) are deposited on opposite end faces of the optical resonators, respectively. A reflectance of the protective film 34 on the output end face of the laser light is about 10 %, and a reflectance of the protective film 36 on the end face opposite to the output end face is about 95 %. After that, each of the processed optical resonators is separated to a chip at widths between about 200 µm and about 600 µm, The chip is mounted on a package or the like, so as to complete the manufacture of the light emitting element shown in FIGs. 1 to 3 is manufactured.

Current versus laser output light characteristics of the thus-manufactured semiconductor light emitting element have been evaluated. As a comparison example, a semiconductor light emitting element, in which only the SiO₂ film is used for a current block layer, is used to conduct the similarity evaluation. The Current versus laser output light characteristics have been measured by using a pulse current of about 50 ns for an environment temperature of about 25°C.

In the semiconductor light emitting element in the comparison example, when the pulse current has been injected and the light output has exceeded about 500 mW, the light output suddenly became 0 mW. Since the light intensity density of the end faces of the optical resonator has been increased, the end face of the semiconductor light emitting element has been damaged. On the other hand, in the semiconductor light emitting element according to the embodiment, even when the light output has exceeded about 1000 mW, the semiconductor light emitting element still works. Since the second current block layers 6 are provided on the edges of the semiconductor light emitting element, an effective window structure is formed so as to decrease the light intensity density on the end faces of the semiconductor light emitting element.

In this way, according to the light emitting element based on the embodiment, it is possible to decrease the light intensity density on the end faces of the semiconductor light emitting element. As a result, it is possible to suppress deterioration on the end face of the semiconductor light emitting element and to achieve the light emitting element having a high light output and a high reliability.

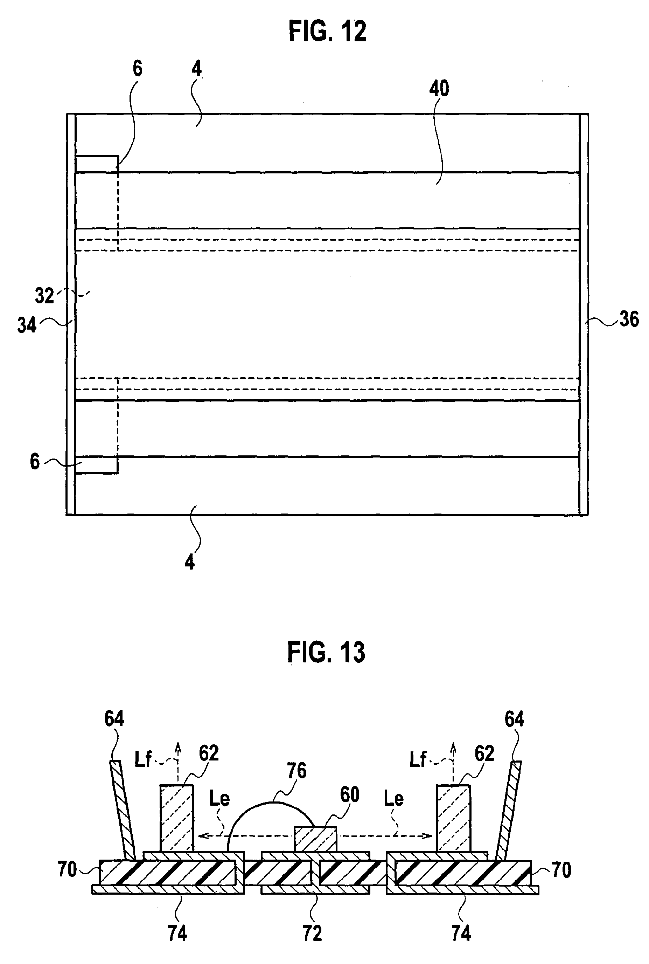

In addition, as shown in FIG. 12, the second current block layer 6 may be formed only on the output end face side of the laser light. Usually, the reflectance of the protective film 36 on the end face opposite to the output end face is higher as compared with the protective film 34 on the output end face of the laser light. In such a case, it is known that the light intensity density inside the optical resonator has a distribution in which the light intensity density is high on the output end face as compared with the end face opposite to the output end face. Therefore, it is adequate to reduce the light intensity density on the output end face by forming the second current block layer 6 on the output end face side.

### (Application Example)

A light emitting device, such as a lighting apparatus, a backlight of a liquid crystal display, a light for a car and the like, will be described below as an application example of the semiconductor light emitting element according to the embodiment of the present invention.

As shown in FIG. 13, the light emitting device according to the application example of the embodiment includes an LD 60 and a fluorescent element 62. The light emitting element according to the embodiment is used as the LD 60. The LD 60 and the fluorescent element 62 are arranged separately from each other on a mounting substrate 70. The mounting substrate 70 includes wirings 72, 74 and a reflector 64. The LD 60 and the wiring 74 are connected to each other by a boding wire 76.

Electric power is supplied to the LD 60 through the wirings 72, 74 and the bonding wire 76. The LD 60 emits a laser light Le towards the fluorescent element 62. The fluorescent element 62 absorbs the laser light Le emitted by the LD 60 and radiates a visible light Lf. The reflector 64 reflects the visible light Lf which is emitted towards the reflector 64 from the fluorescent element 62.

Most of the high energy laser light Le emitted by the LD 60 is absorbed by the fluorescent element 62. Thus, in the light emitting device according to the application example of the embodiment, it is possible to use the high energy excitation light safely and to emit the visible light having high luminance.

### (OTHER EMBODIMENTS)

The present invention has been described as mentioned above. However the descriptions and drawings that constitute a portion of this disclosure shouldnot be perceived as limiting this invention. Various alternative embodiments and operational techniques will become clear to persons skilled in the art from this disclosure.

In the embodiment of the present invention, a semiconductor light emitting element using a nitride based semiconductor is described. However, a semiconductor light emitting element using another group III-V compound semiconductor or a group II-VI compound semiconductor, such as zinc selenide (ZnSe), zinc oxide (ZnO) and the like, may be used.

Additionally, various kinds of semiconductor layers are grown by MOCVD. However, the growing method for the semiconductor layer is not so limited. For example, it is possible to grow the semiconductor layers by molecular beam epitaxy (MBE) and the like.

Additionally, a light emitting device of a visible light is described as the application example of a semiconductor light emitting element. However, as another application of a semiconductor light emitting element according to the embodiment of the present invention, it is possible to use the element in a pickup of an optical disc device, such as a compact disc (CD), a digital versatile disc (DVD) and the like.

Various modifications will become possible for those skilled in the art after storing the teachings of the present disclosure without departing from the scope thereof.

## Claims

1. A semiconductor light emitting element, comprising:
a first clad layer of a first conductivity type provided on a substrate;
an active layer provided on the first clad layer;
a second clad layer of a second conductivity type provided on the active layer, an upper portion of the second clad layer implements a ridge extending in a predetermined direction;
a pair of first current block layers provided on a lower surface of the second clad layer so as to sandwich the ridge along the extending direction of the ridge; and
a pair of second current block layers provided between the first current block layers on the lower surface of the second clad layer and at sidewalls of the ridge so as to be contacted with the first current block layers, sandwiching selectively a region including an edge of the ridge, each of the second current block layers having a refractive index larger than the first current block layers at an emission peak wavelength of the active layer.

2. The semiconductor light emitting element of claim 1, wherein the refractive index of each of the second current block layers is equal to or less than the second clad layer.

3. The semiconductor light emitting element of claim 1, wherein an absolute value of a refractive index difference between the second current block layers and the second clad layer is equal to or less than about 0.4.

4. The semiconductor light emitting element of claim 1, wherein a dimension from one of the sidewalls of the ridge to a side surface of each of the second current block layers measured along a perpendicular direction to the extending direction is equal to or greater than about 0.2 µm.

5. The semiconductor light emitting element of claim 1, wherein a dimension of each of the second current block layers measured along the extending direction is in a range of about 5 µm to about 100 µm.

6. The semiconductor light emitting element of claim 1, wherein each of the first current block layers has a refractive index smaller than the active layer at the emission peak wavelength.

7. The semiconductor light emitting element of claim 1, further comprising:
a first guide layer provided between the first clad layer and the active layer; and
a second guide layer provided between the active layer and the second clad layer.

8. The semiconductor light emitting element of claim 7, wherein each of the active layer, the first and second clad layers, and the first and second guide layers is a nitride based compound semiconductor.

9. The semiconductor light emitting element of claim 1, wherein each of the first current block layers is a silicon oxide film.

10. The semiconductor light emitting element of claim 1, wherein each of the second current block layers is an insulating film containing zirconium oxide or titanium oxide.

11. A semiconductor light emitting element, comprising:
a first clad layer of a first conductivity type provided on a substrate;
an active layer provided on the first clad layer;
a second clad layer of a second conductivity type provided on the active layer, an upper portion of the second clad layer implements a ridge extending in a predetermined direction;
a pair of first current block layers provided on a lower surface of the second clad layer so as to sandwich the ridge along the extending direction of the ridge, each of the first current block layers having a refractive index less than the active layer at an emission peak wavelength of the active layer; and
a pair of second current block layers provided between the first current block layers on the lower surface of the second clad layer and at sidewalls of the ridge so as to be contacted with the first current block layers, sandwiching selectively a region including an edge of the ridge, each of the second current block layers having a refractive index larger than the first current block layers and equal to or less than the second clad layer at the emission peak wavelength.

12. The semiconductor light emitting element of claim 11, wherein an absolute value of a refractive index difference between the second current block layers and the second clad layer is equal to or less than about 0.4.

13. The semiconductor light emitting element of claim 11, wherein a dimension from one of the sidewalls of the ridge to a side surface of each of the second current block layers measured along a perpendicular direction to the extending direction is equal to or more than about 0.2 µm.

14. The semiconductor light emitting element of claim 11, wherein a dimension of each of the second current block layers measured along the extending direction is in a range of about 5 µm to about 100 µm.

15. The semiconductor light emitting element of claim 11, further comprising:
a first guide layer provided between the first clad layer and the active layer; and
a second guide layer provided between the active layer and the second clad layer.

16. The semiconductor light emitting element of claim 16, wherein each of the active layer, the first and second clad layers, and the first and second guide layers is a nitride based compound semiconductor.

17. The semiconductor light emitting element of claim 11, wherein each of the first current block layers is a silicon oxide film.

18. The semiconductor light emitting element of claim 11, wherein each of the second current block layers is an insulating film containing zirconium oxide or titanium oxide.
